**Europäisches Patentamt**

**European Patent Office**

**Office européen des brevets**

(19)

(11) Veröffentlichungsnummer : **0 000 472**
**B1**

(12) **EUROPÄISCHE PATENTSCHRIFT**

(45) Veröffentlichungstag der Patentschrift :
11.02.81

(21) Anmeldenummer : 78100195.3

(22) Anmeldetag : 19.06.78

(51) Int. Cl.³ : **H 01 L 27/06**, G 11 C 11/40

(54) Hochintegrierte Halbleiteranordnung enthaltend eine Dioden-/Widerstandskonfiguration.

(30) Priorität : 26.07.77 DE 2733615

(43) Veröffentlichungstag der Anmeldung :
07.02.79 (Patentblatt 79/03)

(45) Bekanntmachung des Hinweises auf die Patenterteilung : 11.02.81 Patentblatt 81/06

(84) Benannte Vertragsstaaten :
DE FR GB

(56) Entgegenhaltungen :
IBM TECHNICAL DISCLOSURE BULLETIN,
Band 14, Juni 1971
New York
W.W.WU : « Diode resistor compensation for floating
gates »,
Seite 236

IBM TECHNICAL DISCLOSURE BULLETIN,
Band 19, November 1976
New York
M.A. BATTISTA et al. « Variable transition device
transistor »,
Seiten 2073-2074

(73) Patentinhaber : **International Business Machines Corporation**

**Armonk, N.Y. 10504 (US)**

(72) Erfinder : **Klein, Wilfried**
**Ulmenstrasse 86**
**D-7031 Holzgerlingen (DE)**
Erfinder : **Klink, Erich, Dipl.-Ing.**
**Max-Eyth-Strasse 34**
**D-7036 Schönaich (DE)**
Erfinder : **Rudolph, Volker, Dipl.-Phys.**
**Finkenweg 20**
**D-7031 Aidlingen-Dachtel (DE)**
Erfinder : **Wernicke,Friedrich,Dipl.-Ing.**
**Herdlauchring 6**
**D-7036 Schönaich (DE)**

(74) Vertreter : **Mönig, Anton, Dipl.-Ing.**
**Schönaicher Strasse 220**
**D-7030 Böblingen (DE)**

## Hochintegrierte Halbleiteranordnung enthaltend eine Dioden-/Widerstandskonfiguration

Die Erfindung bezieht sich auf eine hochintegrierte Halbleiteranordnung enthaltend eine Dioden-/Widerstandskonfiguration gemäß dem Oberbegriff des Patentanspruchs 1, die vorzugsweise als mit den Auswahlleitungen einer integrierten Speicheranordnung zusammenwirkende Trenndiode mit einem hochohmigen Ableitwiderstand Anwendung finden kann.

Ein ständiges Bestreben bei der Entwicklung integrierter Halbleiterschaltungskonzepte besteht darin, die einzelnen oder mehreren Schaltungselemente möglichst flächensparend auszulegen, um so auf einem Halbleiterchip möglichst viele Schaltungselemente bzw.-funktionen unterbringen zu können. Derartige Erhöhungen des Integrationsgrades wirken sich unmittelbar günstig auf die Kosten, die Zuverlässigkeit etc. der daraus hergestellten Produkte aus.

In der US-PS 3 631 311 ist beispielsweise eine integrierte Halbleiterschaltungsanordnung behandelt, die einen Transistor mit einem unmittelbar damit integrierten Basisableitwiderstand vorsieht. Der Widerstandsbereich erstreckt sich dabei einseitig bis in den umgebenden Isolationsbereich, wodurch zusätzlich ein äußerer Widerstandsanschluß eingespart werden kann. In einer ähnlichen Konfiguration ist nach der Veröffentlichung im IBM Technical Disclosure Bulletin Vol. 11, N° 11, April 1969, Seite 1439 der zusammen mit der Transistorbasis integrierte Ableitwiderstand als sog. Pinch-bzw. Dumbbell-Widerstand ausgelegt. Bei einem solchen Pinch-Widerstand handelt es sich um einen doppeltdiffundierten Widerstand, bei dem der Leitungskanal des eigentlichen Widerstandsbereiches durch Einbringung eines weiteren Dotierungsbereichs vom entgegengesetzten Leitfähigkeitstyp in seinem Querschnitt eingeschnürt wird. Damit lassen sich relativ hochohmige Widerstandswerte erreichen, ohne daß damit ein ansonsten bei Ausnutzung des Bahnwiderstandes zwangsläufiger hoher Halbleiterflächenbedarf verbunden wäre.

Schließlich ist in der DT-Auslegeschrift 1 808 342 sowie in der US-PS 4 005 469 eine relativ hochintegrierte Kombination eines Transistors mit einer zugehörigen Antisättigungsdiode angegeben. Dabei wird durch einen übergreifenden Metallkontakt gleichzeitig auf dem Halbleitermaterial des einen Leitfähigkeitstyps ein ohmscher sowie auf dem umgebenden Halbleitermaterial vom anderen Leitfähigkeitstyp ein gleichrichtender Schottky-Kontakt gebildet.

Die Erfindung, wie sie in den Ansprüchen gekennzeichnet ist, löst die Aufgabe, eine möglichst flächensparende integrierte Halbleiteranordnung für eine Dioden-/Widerstandskonfiguration anzugeben, die insbesondere mit möglichst wenig äußeren Anschlußkontakten und Zwischenverbindungsleiterzügen auskommt und mittels konventioneller Verfahrensschritte herstellbar ist. Dabei soll der Widerstand für hohe Widerstandswerte auslegbar sein, wie sie für Ableitwiderstände benötigt werden und eine möglichst geringe parasitäre Kapazität aufweisen.

Zusammengefaßt sieht die Erfindung die extrem weitgehende Integration einer Schottky-Diode mit einem damit verbunden Pinch-Widerstand vor, dessen Abschnürdotierungsbereich gleichzeitig das Kathodenanschlußdotierungsgebiet der Schottky-Diode darstellt. Der Schottky-Kontakt wird dabei gleichzeitig mit dem Widerstandsanschluß durch eine gemeinsame den zugehörigen P/N-Übergang überlappende Metallelektrode gebildet. Schließlich läßt sich auch der weitere Kontakt für den Widerstand dadurch einsparen, daß man den Widerstandsbereich bis in den umgebenden Trenndotierungsbereich hinein erstreckt, über den dann die entsprechende Spannungszufuhr beim Einsatz des Widerstandes als Ableitwiderstand erfolgt.

In diesem Zusammenhang ist festzustellen, daß des erste Teil des Anspruchs 1 (Oberbegriff) sowie die besondere Ausführungsart nach Anspruch 4 aus der Zeitschrift IMB Technical Disclosure Bulletin, Vol. 14, Juni 1971, N° 1, Seite 236, bekannt ist.

Ferner ist im Hinblick auf Anspruch 9 aus dieser Literaturstelle bekannt, daß der Pinch-Widerstand einen Pleitend dotierten widerstandsbereich innerhalb eines umgebenden N-Leitenden Halbleitermaterials in einem Umgebungsbereich aufweist, daß der Abschnürdotierungsbereich des Pinch-Widerstandes ein zwischen den beiden Enden des Widerstands bereichs angeordneter relativ hochdotierter N Leitender Bereich ist, dessen Eindringtiefe geringer als die des Widerstandsbereichs ist.

Die nach den Maßnahmen der Erfindung aufgebaute Dioden-/Widerstandskonfiguration zeichnet sich durch einen außerordentlich geringen Bedarf an aktiver Halbleiterfläche aus, da sie unter Vermeidung einer Zwischen-isolation mit einem Minimum an äußeren Anschlüssen und Zwischenverbindungen auskommt. Der zur Verfügung stehende hohe Widerstandswert mit nur geringem parasitären kapazitiven Einfluß erlaubt eine vielseitige Anwendbarkeit, z. B. als Trenndioden-/Ableitwiderstandskombination mit geringem eigenen Verlustleistungsverbrauch.

Die Erfindung wird im folgenden anhand von Ausführungs- und Anwendungsbeispielen die einen Wog zur Ausführung der Erfindung angeben, unter Zuhilfenahme der Zeichnungen näher erläutert.

Es zeigen :

Fig. 1 das elektrische Ersatzschaltbild der Dioden-/Widerstandskombination ;

Fig. 2A u. 2B ein bevorzugtes Ausführungsbeispiel der Erfindung in einer Draufsicht sowie einem perspektivischen Querschnitt durch die zugehörige Halbleiterstruktur ;

Fig. 3 eine Draufsicht auf eine konventionell integrierte Dioden-/Widerstandskombination, mit der die Erfindung vergleichbar ist und

Fig. 4 das elektrische Schaltbild einer Speicheransteuerung zur Erläuterung der vorteilhaften Anwendung der Erfindung.

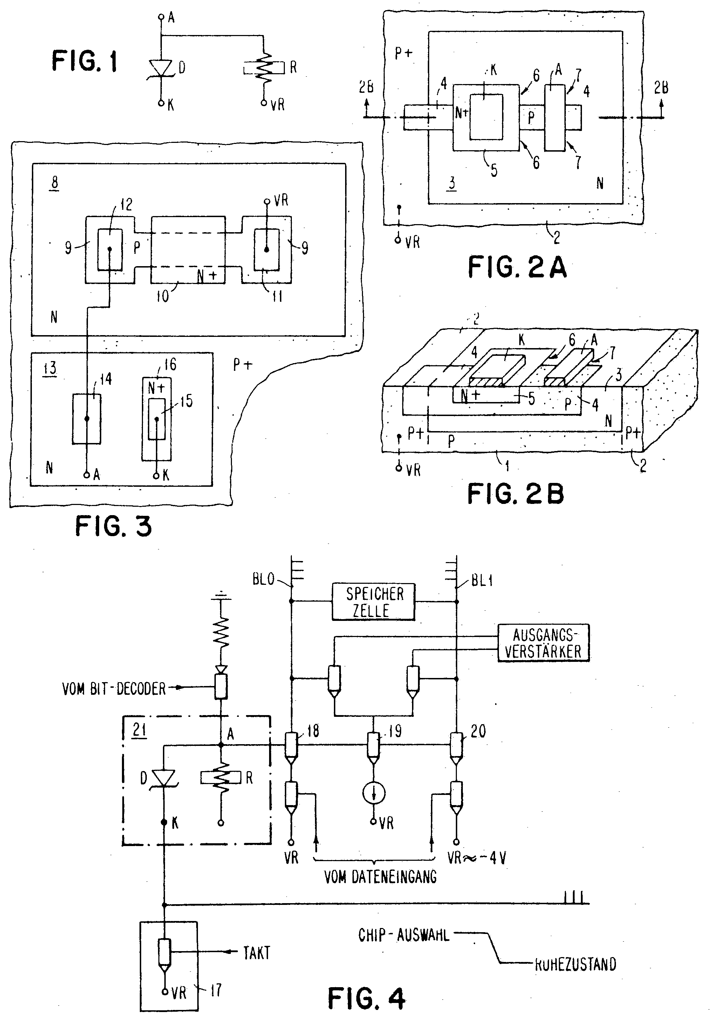

Fig. 1 zeigt das elektrische Ersatzschaltbild der Dioden-/Widerstandskonfiguration, die nach den Maßnahmen der Erfindung besonders vorteilhaft im Sinne einer hohen Integrationsdichte als Halbleiteranordnung ausgebildet werden kann. Bei der Diode D handelt es sich um eine Schottky-Diode mit dem Anondenanschluß A und dem Kathodenanschluß K. Mit dem Anodenanschluß A ist der Widerstand R verbunden, an dessen anderem Anschluß eine Referenzspannung VR anlegbar ist. Bei einer Benutzung des Widerstandes R als Ableitwiderstand, kann VR beispielsweise die negativste in der Schaltung vorkommende Spannung sein. Das für den Widerstand R in Fig. 1 benutzte Symbol soll darauf hinweisen, daß es sich dabei um einen (an sich bekannten Pinch-Widerstand mit einem Abschnürdotierungsbereich im Verlauf des Widerstandsbereiches handelt.

Fig. 2A zeigt nun eine besonders vorteilhaftes Ausführungsbeispiel für die hochintegrierte Ausführung der in Fig. 1 gezeigten Schaltung als Halbleiteranordnung. Fig. 2B zeigt ergänzend dazu Querschnittsdarstellung entlang der in Fig. A2 bezeichneten Schnittlinie. Zur weiteren Verdeutlichung des Aufbaus der Halbleiteranordnung ist die Querschnittsdarstellung in Fig. 2B im Sinne einer perspektivischen Darstellung erweitert. Die Herstellung der erfindungsgemäßen Dioden-/Widerstandskombination kann mittels konventioneller auf dem Gebiet der integrierten Halbleiterschaltungen üblicher Verfahren erfolgen, weshalb darauf im vorliegenden Zusammenhang nicht näher eingegangen zu werden braucht. So kann beispielsweise von einem P leitenden Halbleitersubstrat 1, z. B. aus einkristallinem Silicium, ausgegengen werden. In dem Substrat 1 können ggf. vergrabene Dotierungsbereiche in Form der bekannten Subkollektorregionen vorgesehen werden, die jedoch im vorliegenden Fall der besseren Übersichtlichkeit wegen nicht dargestellt sind. Auf dem Substrat 1 wird bei bipolaren Halbleiteranordnungen anschließen gewöhnlich mittels bekannter Epitaxieverfahren eine Epitaxieschicht vom entgegengesetzten Leitfähigkeitstyp aufgebracht, die durch rahmenförmige Trenndotierungsbereiche 2 in einzelne, abgegrenzte Umgebungsbereiche 3 aus N leitendem Halbleitermaterial aufgeteilt wird. Diese abgegrenzten Umgebungsbereiche 3 der Epitaxieschicht dienen in bekannter Weise zur Aufnahme der darin auszubildenden Halbleiterbauelemente.

Im vorliegenden Fall sind in einem solchen abgerenzten Umgebungsbereich 3 aus N leitendem Halbleitermaterial sowohl die Diode D als auch damit integriert der Widerstand R angeordnet. Der Widerstand R besteht aus dem langgestreckten P leitenddotierten Widerstandsbereich 4, dessen Querschnitt in der für Pinch-Widerstände üblichen Art durch Einbringung eines Abschnürdotierungsbereiches 5 vom entgegengesetzten Leitfähigkeitstyp, im vorliegenden Fall aus N⁺ leitendem Halbleitermaterial, eingeschnürt ist. Der Abschnürdotierungsbereich 5 weist dabei eine geringere Eindringtiefe als der Widerstandsbereich 4 auf. In der Querrichtung erstreckt sich der Abschnürdotierungsbereich 5 über die Breite des Widerstandsbereichs 4 hinaus (bei 6), so daß er dort in Verbindung mit dem den Widerstandsbereich 4 umgebenden Halbleitermaterial im Umgebangsbereich 3 vom gleichen Leitfähigkeitstyp steht. Zur Herstellung des Widerstandsbereichs 4 und des Abschnürdotierungsbereichs 5 können die konventionellen Dotierungsverfahren, wie Diffusion oder Ionenimplantation, Anwendung finden.

Zur Herstellung eines äußeren Anschlusses ist der Widerstandsbereich 4 an einem Ende, im Ausführungsbeispiel der Fig. 2 am rechten Ende, mit einer Metallelektrode A ausgestattet. Diese Metallelektrode A bildet mit dem P leitenden Widerstandsbereich 4 einen ohmschen Kontakt. Besonders vorteilhaft ist es im Rahmen der vorliegenden Erfindung, die Metallelektrode A als übergreifenden Kontakt auszubilden, so daß sie sich auch über den Widerstandsbereich 4 hinaus in das umgebende N leitende material des Umgebungsbereichs 3 erstreckt. Dadurch ist im vorliegenden Fall durch die Metallelektrode A neben einem ohmschen Kontakt des Widerstandsbereichs 4 ein gleichrichtender Schottky-Kontakt auf dem N leitenden Halbleitermaterial des Umgebungsbereichs 3 gebildet. Die für die Erzielung von gleichrichtenden Schottky-Kontakten einzuhaltenden Bedingungen bezüglich der Metall-Halbleiterpaarungen sind in der Halbleitertechnik gut bekannt. Es ist beispielsweise bekannt, daß Metallkontakte aus Aluminium, Platin usw. auf schwach dotiertem N leitendem Silicium einen Schottky-Kontakt bilden. Der somit neben dem ohmschen Kontakt auf dem Widerstandsbereich 4 durch die Ausbildung des Metallkontaktes A als übergreifender Kontakt hergestellte Schottky-Übergang (bei 7) bildet somit gleichzeitig die Anode der in Fig. 1 im Schaltbild dargestellten Schottky-Diode D. Statt üblicherweise zwei Kontakten wird somit nur ein einziger Kontakt benötigt, was eine entsprechende Einsparung an aktiver Halbleiterfläche mit sich bringt.

Auf dem Abschnürdotierungsbereich 5 ist ebenfalls eine als Metallelektrode aus gebildete Anschlußkontaktierung für den äußeren Anschluß vorgesehen. Diese Metallelektrode ist mit K bezeichnet, weil über sie die Kathode der Schottky-Diode D nach außen zugänglich ist. Dabei wird nun ausgenutzt, daß der Abschnürdotierungsbereich 5 neben dieser Funktion im Rahmen des Pinch-Widerstandsaufbaus infolge seiner Erstreckung in das N leitende Halbleitermaterial des den Widerstandsbereich 4 umgebenden Umgebungsbereichs 3 gleichzeitig das Kathodenanschlußdotierungsgebiet für die aus dem Metallkontakt A und das N leitende Halbleitermaterial des Umgebungsbereichs 3 gebildete Schottky-Diode darstellt. Die Metallelektrode K kann aus demselben Metall wie der Metallkontakt A bestehen, weil der Dotierungsgrad des Abschnürdotierungsbereichs 5 höher ist als des Halbleitermaterials im Umgebungsbereich 3, so daß die Metallelektrode K einen ohmschen Kontakt bildet. Auch die Herstellung des Metallkontaktes A und der Metallelektrode K kann mittels konventioneller Verfahren, z. B. mittels einer Aluminiumbedampfung, Kathodenzerstäubung usw., erfolgen. In diesem Zusammenhang ist ferner anzumerken, daß sowohl die Ausbildung der Dotierungsbereiche wie auch der Metallisierungen zusammen mit den entsprechenden Verfahrensschritten für die weiteren auf demselben Halbleiterchip herzustellenden Schaltungselemente durchgeführt werden können, wobei z. B. der P leitende Widerstandsbereich 4 gleichzeitig mit der Basisdotierung, der Abschnürdotierungsbereich 5 mit der Emitterdotierung und die Kontaktierung mit den übrigen Metallisierungen für die Anschlüsse und Leiterzüge auf dem Chip vorgenommen werden kann.

Mit dem bisher beschriebenen Aufbau der Halbleiteranordnung sind somit von der in Fig. 1 dargestellten Schaltung die Diode D mit ihren äußeren Anschlüssen A und K sowie der mit dem Anodenanschluß A verbundene Widerstand R fertiggestellt. Bei einem Einsatz des Widerstandes R als Ableitwiderstand zum negativsten in der Schaltung vorkommenden Potential kann schließlich nach einer besonderen Ausführungsart der Erfindung der ansonsten erforderliche Kontakt auf dem Widerstandsbereich 4 dadurch eingespart werden, daß man den Widerstandsbereich 4 mit seinem anderen, im gezeigten Ausführungsbeispiel linken Ende bis in den den Umgebungsbereich 3 umgebenden Trenndotierungsbereich 2 hinein erstreckt. Da die Trenndotierungsbereiche 2 zur Bildung gesperrter P/N-Übergänge in der Regel auf dem niedrigsten in der Schaltung vorkommenden Potential liegen, erhält der Widerstand R auf diese Weise an seinem Anschluß für das Referenzpotential VR die entsprechende Spannungszuführung, ohne einen besonderen flächenaufwendigen zusätzlichen Kontakt vorsehen zu müssen. Dabei kann man sich zunutze machen, daß die Trenndotierungsbereiche 2 infolge ihrer untereinander bestehenden Verbindungen nur einen oder jedenfalls nur wenige Anschlüsse auf dem gesamten Chip erfordern.

Insgesamt ist somit die in Fig. 1 gezeigte Dioden-/Widerstandskombination mit einer außerordentlich hohen Integrationsdichte und lediglich zwei externen Kontakten realisierbar, was im Vergleich zu einer üblichen Auslegung eines derartigen Schaltungsteils in einer erheblichen Flächeneinsparung resultiert, was anhand eines maßstabsgetreuen Flächenvergleichs unter Zuhilfenahme der Fig. 3 veranschaulicht werden soll.

Fig. 3 zeigt eine konventionelle, integrierte Halbleiteranordnung für den in Fig. 1 gezeigten Schaltungsteil. Dabei wurden dieselben Auslegungsrichtlinien, d. h. Abstandsvorschriften, minimale Bereichsgrößen usw. wie in Fig. 2A zugrunde gelegt. In Fig. 3 ist in einem ersten isolierten Halbleiterbereich 8 der Pinch-Widerstand mit seinem P leitenden Widerstandsbereich 9 und dem Abschnürdotierungsbereich 10 sowie den beiden äußeren Anschlüssen 11 und 12 ausgebildet. Isoliert davon ist in einem zweiten Halbleiterbereich 13 aus N leitendem Halbleitermaterial die Schottky-Diode hergestellt. Die Metallelektrode 14 bildet dabei den Schottky-Übergang für die Anode, während die weitere Metallelektrode 15 auf dem $N^+$ leitenden Dotierungsbereich 16 einen ohmschen Kontakt für die Kathode der Schottky-Diode bildet. Ein Flächenvergleich der konventionellen Ausführung nach Fig. 3 mit der Ausführung nach einem bevorzugten Ausführungsbeispiel der Erfindung entsprechend Fig. 2A ergibt eine Flächeneinsparung von etwa 54 %, wenn man die Dioden-/Widerstandskonfiguration nach Fig. 1 gemäß der Erfindung integriert.

Mit einer derartig hinsichtlich des Flächenbedarfs attraktiven Integration steht dem mit der Auslegung von integrierten Schaltungen befaßten Fachmann eine Schaltungsanordnung zur Verfügung, die er mit Vorteil in Verbindung mit den verschiedensten Schaltungen einsetzen kann. In Fig. 4 ist als ein Anwendungsbeispiel der Einsatz der erfindungsgemäßen Dioden-/Widerstandskonfiguration im Ansteuerungsbereich eines Halbleiterspeichers dargestellt. Fig. 4 stellt einen Ausschnitt aus einer Speicheranordnung dar, die auf ein Bitleitungspaar BL0, BL1 beschränkt ist. Soweit es darauf im vorliegenden Fall nicht ankommt, sind die entsprechenden Schaltungsteile lediglich schematisch angedeutet, z. B. die Speicherzellen, Ausgangsverstärker usw. Um bei derartigen Halbleiterspeichern zu kurzen Zykluszeiten bei niedriger Verlustleistungsaufnahme zu kommen, müssen alle Wort- und Bit-Auswahlleitungen nach jeder Zugriffsperiode durch eine getaktete Kontrollogik auf definierte Gleichspannungspotentiale für den Ruhezustand aufgeladen bzw. gebracht werden. Zu diesem Zweck sind eine Reihe von Transistoren als Stromsenken und Stromquellen vorgesehen, die von einem schematisch angedeuteten Schaltkreis 17 gesteuert werden. Über den Schaltkreis 17 können die Basisanschlüsse der Transistoren 18, 19 und 20 bei nicht vorliegender Selektion auf das Referenzpotential VR, z. B. das kleinste in der Schaltung vorkommende Potential, heruntergezogen werden. Der Spannungsabfall über der Trenndiode sei dabei vernächlässigt. Jede derartige Gruppe von zu einem Bitleitungspaar oder zu einer Wortleitung gehörenden Transistoren ist von den entsprechenden Transistoren eines anderen Bitleitungspaares oder einer anderen Wortleitung durch die in dem eingerahmten Bereich 21 dargestellte Dioden-/Widerstandskonfiguration entsprechend Fig. 1 entkoppelbar. Bei Vorliegen eines Chipauswahlsignals sind alle Entkoppeldioden D auf dem betreffenden Chip in Sperrichtung vorgespannt, so daß für die Speicherzellen auf dem Chip Einschreib-bzw. Auslesevorgänge durchgeführt werden können. Um bei gesperrter Entkoppeldiode D zu gewährleisten, daß die zu nicht selektierten Auswahlleitungen gehörenden Transistoren (entsprechend 18, 19 und 20) nicht zufällig durch einen durch Leckströme bedingten Potentialanstieg am Punkt A (Anode der Entkoppeldiode D) eingeschaltet werden können, ist zusätzlich ein Ableitwiderstand R parallel zum Anodenanschluß der Entkoppeldiode D vorgesehen. Damit über den Ableitwiderstand jedoch im Selektionsfall nur ein möglichst geringer Strom fließen kann, sollte der Ableitwiderstand R einen möglichst hohen Widerstandswert sowie eine möglichst parasitäre Kapazität aufweisen. Diese Eigenschaften gehen nämlich direkt in die erzielbaren Schaltzeiten sowie die Verlustleistung ein.

Es ist ersichtlich, daß im Rahmen einer integrierten Halbleiterspeicheranordnung eine derartige Entkoppeldioden-/Ableitwiderstandskonfiguration auf möglichst kleinem Raum realisieren lassen muß, um nicht eine Einbuße an auf dem Chip vorzusehenden Speicherzellen in Kauf nehmen zu müssen. Wie oben gezeigt wurde, wird diese außerordenlich hochintegrierte Auslegung durch die Erfindung ermöglicht.

**Ansprüche**

1. Hochintegrierte Halbleiteranordnung enthaltend eine Dioden-Widerstandskonfiguration, wobei der Widerstand (R) als Pinch-Widerstand ausgebildet ist, dessen Abschnürdotierungsbereich (5) größer als die Querabmessung seines, den Leitungskanal darstellenden Widerstandsbereiches (4) ist, dadurch gekennzeichnet, daß der Abschnürdotierungsbereich (5) gleichzeitig das Kathodenanschluß-Dotierungsgebiet für die als Schottky-Diode ausgelegte Diode (D) darstellt, und daß auf dem Widerstandsbereich (4) mit Abstand von dem Abschnürdotierungsbereich (5) ein über die Oberfläche des Widerstandsbereichs (4) hinausgreifender Metallkontakt (A) vorgesehen ist, der auf dem Widerstandsbereich (4) einen ohmschen Anschluß und mit dem den Widerstandsbereich (4) umgebenden Halbleitermaterial (3) vom dazu entgegengesetzten Leitfähigkeitstyp einen gleichrichtenden Übergang (bei 7) für die Anode der Schottky-Diode bildet und daß an einem Ende des Widerstandsbereiches (4) ein Anschluß für sein elektrisches Potential vorgesehen ist.

2. Hochintegrierte Halbleiteranordnung nach Anspruch 1, dadurch gekennzeichnet, daß auf dem Abschnürdotierungsbereich (5) eine Anschlußkontaktierung (K) für den Kathodenanschluß der Schottky-Diode (D) vorgesehen ist.

3. Hochintegrierte Halbleiteranordnung nach Anspruch 2, dadurch gekennzeichnet, daß der Abschnürdotierungsbereich (5) relativ zum umgebenden Halbleitermaterial (3) vom gleichen Leitfähigkeitstyp einen höheren Dotierungsgrad aufweist, der mindestens so hoch ist, daß eine als Metallelektrode (K) ausgebildete Anschlußkontaktierung für den Kathodenanschluß der Schottky-Diode einen ohmschen Kontakt mit dem Abschnürdotierungsbereich (5) bildet.

4. Hochintegrierte Halbleiteranordnung nach einem der Ansprüche 1 bis 3, dadurch gekennzeichnet, daß der Widerstandsbereich (4) derart angeordnet ist, daß er sich an einem Ende bis in einen insbesondere für die elektrische Isolation der Dioden-Widerstandskonfiguration vorgesehenen Trenndotierungsbereich (2) vom gleichen Leitfähigkeitstyp erstreckt, so daß der Trenndotierungsbereich (2) dem Widerstandsbereich (4) sein elektrisches Potential (VR) zuführt.

5. Hochintegrierte Halbleiteranordnung nach einem der Ansprüche 1 bis 4, dadurch gekennzeichnet, daß der Widerstand einen hochohmigen Ableitwiderstand (R) parallel der Schottky-Diode (D) darstellt.

6. Hochintegrierte Halbleiteranordnung nach Anspruch 5, dadurch gekennzeichnet, daß der Ableitwiderstand (R) im Sperrzustand der Schottky-Diode (D) einen Potentialanstieg an der Anode der Schottky-Diode und damit ein Leitendwerden der Schottky-Diode verhindert.

7. Hochintegrierte Halbleiteranordnung nach einem der Ansprüche 1 bis 6, dadurch gekennzeichnet, daß die Dioden-Widerstandskonfiguration in den Auswahlleitungen für eine elektrische Speicherzellenanordnung vorgesehen ist (Fig. 4).

8. Hochintegrierte Halbleiteranordnung nach Anspruch 7, dadurch gekennzeichnet, daß über die Dioden-Widerstandskonfiguration die elektrische Trennung bzw. Verbindung der Auswahlleitungen von bzw. mit weiteren Schaltkreisen für die definierte Auf-bzw. Entladung der Auswahlleitungen in bzw. zwischen den Zugriffsoperationen zu den Speicherzellen herstellbar ist.

9. Halbleiteranordnung nach einem der Ansprüche 1 bis 8, dadurch gekennzeichnet, daß der Pinch-Widerstand einen P leitend dotierten Widerstandsbereich (4) innerhalb eines umgebenden N leitenden Halbleitermaterials in einem ümgebungsbereich (3) aufweist, daß der Abschnürdotierungsbereich (5) des Pinch-Widerstandes ein zwischen den beiden Enden des Widerstandsbereiches (4) angeordneter relativ hochdotierter N leitender Bereich ist, dessen Eindringtiefe geringer als die des Widerstandsbereichs (4) ist, und daß der Metallkontakt (A) an einem Ende des Widerstandsbereichs (4) angeordnet ist.

**Claims**

1. Highly integrated semiconductor arrangement containing a diode-resistor configuration, the resistor (R) being designed as a pinch resistor whose pinch-doping area (5) is larger than the transverse dimension of the resistor area (4) representing the conductive channel, characterized in that in pinch-doping area (5) forms at the same time the cathode contact doping area for the diode (D) designed as a Schottky diode, and that on the resistor area (4) spaced from the pinch-doping area (5) a metal contact (A) extending over the surface on the resistor area (4) is provided which forms an ohmic contact on the resistor area, and a rectifying junction (at 7) for the Schottky diode with the semiconductor material (3) surrounding the resistor area (4) and of the opposite conductivity type, and that at one end of the resistor area (4) a connection for its electrical potential is provided.

2. Highly integrated semiconductor arrangement as claimed in claim 1, characterized in that on the pinch-doping area (5) a contact terminal (K) is provided for the cathode contact of the Schottky diode (D).

3. Highly integrated semiconductor arrangement as claimed in claim 2, characterized in that the pinch-doping area (5) has relative to the surrounding semiconductor material (3) of the same conductivity type a higher doping degree permitting at least the forming of an ohmic contact by a contact terminal designed as metal electrode (K) for the cathode contact of the Schottky diode, with the pinch-doping area (5).

4. Highly integrated semiconductor arrangement as claimed in one of claims 1 to 3, characterized in that the resistor area (4) is arranged in such a manner that at one end it extends into a doping area (2) of the same conductivity type provided primarily for the electric isolation of the diode-resistor configuration, so that the doping area (2) applies to the resistor area (4) its electric potential (VR).

5. Highly integrated semiconductor arrangement as claimed in one of claims 1 to 4, characterized in that the resistor represents a highly ohmic discharge resistor (R) in parallel to the Schottky diode (D.)

6. Highly integrated semiconductor arrangement as claimed in claim 5, characterized in that the discharge resistor (R) prevents in the reversed bias state of the Schottky diode (D) a rise of the potential at the anode of the Schottky diode, and thus prevents the Schottky diode from becoming conductive.

7. Highly integrated semiconductor arrangement as claimed in one of claims 1 to 6, characterized in that the diode-resistor configuration is provided in the selection lines for an electric storage cell arrangement (Fig. 4).

8. Highly integrated semiconductor arrangement as claimed in claim 7, characterized in that via the diode-resistor configuration the selection lines can be electrically separated or connected to or from further circuits for the defined charge or discharge of the selection lines in or between access operations to the storage cells.

9. Semiconductor arrangement as claimed in one of claims 1 to 8, characterized in that the pinch resistor has a P-conductively doped resistor area (4) within a surrounding N-conductive semiconductor material in a surrounding area (3), that the pinch doping area (5) of the pinch resistor is a relatively highly doped N-conductive area arranged between both ends of the resistor area (4) whose junction depth is lower than that of the resistor area (4), and that the metal contact (A) is arranged at one end of the resistor area (4).

**Revendications**

1. Dispositif semi-conducteur à haute densité d'intégration comportant une structure diode-résistance dans laquelle la résistance (R) fait fonction de résistance de pincement, la région dopée de pincement (5) est plus grande que la dimension transversale de sa région de résistance (4) formant le canal conducteur, caractérisé en ce que la région dopée de pincement (5) constitue en même temps la région dopée de contact de cathode pour la diode de Schottky (D), que sur la région de résistance (4), écartée de la région dopée de pincement (5), est prévu un contact métallique (A) dépassant la surface de la région de résistance (4) qui forme, avec la région de résistance (4), un contact ohmique et, avec le matériau semi-conducteur (3) entourant la région de résistance (4) qui est du type de conductivité opposé, une jonction redresseuse (à 7) qui constitue l'anode de la diode de Schottky, et enfin qu'à une extrémité de la région de résistance (4) est prévu un contact pour son potentiel électrique.

2. Dispositif semi-conducteur à haute densité d'intégration selon la revendication 1, caractérisé en ce qu'une borne de connexion (K) est prévue sur la région dopée de pincement (5) pour constituer le contact de cathode de la diode de Schottky (D).

3. Dispositif semi-conducteur à haute densité d'intégration selon la revendication 2, caractérisé en ce que la région dopée de pincement (5) par rapport au matériau semi-conducteur entourant (3) du même type de conductivité a une concentration de dopage plus élevée, au moins suffisamment élevée pour que la borne de connexion du contact de cathode de la diode de Schottky, faisant fonction d'électrode métallique (K), forme un contact ohmique avec la région dopée de pincement (5).

4. Dispositif semi-conducteur à haute densité d'intégration selon l'une quelconque des revendications 1 à 3, caractérisé en ce que la région de résistance (4) est disposée de sorte qu'elle pénètre à une extrémité dans une région dopée d'isolation (2) et de même type de conductivité, cette dernière région étant prévue en particulier pour assurer l'isolation électrique de la structure diode-résistance, et en ce que la région dopée de séparation (2) fournit à la région de résistance (4) son potentiel électrique (VR).

5. Dispositif semi-conducteur à haute densité d'intégration selon l'une quelconque des revendications 1 à 4, caractérisé en ce que la résistance (R) constitue une résistance de décharge de forte valeur disposée en parallèle avec la diode de Schottky (D).

6. Dispositif semi-conducteur à haute densité d'intégration selon la revendication 5, caractérisé en ce que la résistance de décharge (R) bloque, lorsque la diode de Schottky (D) est polarisée en inverse, la montée du potentiel de l'anode de la diode de Schottky et l'empêche de devenir conductrice.

7. Dispositif semi-conducteur à haute densité d'intégration selon l'une quelconque des revendications 1 à 6, caractérisé en ce que la structure diode-résistance est introduite, dans les lignes de sélection d'une configuration de cellules de mémoire (Figure 4).

8. Dispositif semi-conducteur à haute densité d'intégration selon la revendication 7, caractérisé en ce que grâce à la structure diode-résistance, les lignes de sélection peuvent être connectées à, ou déconnectées des circuits supplémentaires pour la charge ou décharge contrôlée des lignes de sélection pendant ou entre les opérations d'accès aux cellules mémoire.

9. Dispositif semi-conducteur à haute densité d'intégration selon l'une quelconque des revendications 1 à 8, caractérisé en ce que la résistance de pincement est constituée par une région résistive (4) du type de conductivité P, entourée par une région (3) du type de conductivité N, que la région de pincement (5) forme une région relativement fortement dopée du type de conductivité N, qui est disposée entre les deux extrémités de la région résistive (4), sa profondeur de jonction étant inférieure à celle de la région résistive (4) et qu'enfin un contact métallique (A) est disposé sur une extrémité de la région résistive (4).

**FIG. 1**

**FIG. 2A**

P+

2B ← 2B

4    K    6    A    7    4

N+    P

5    6    7

3    N

VR    2

**FIG. 3**

8

VR

12

9    P    9

10    N+    11

N

P+

13    16

14    N+

15

N

A    K

**FIG. 2B**

2

4    K    6    A    7

N+    5    P    4    3    N

P+    P    P+

VR    1    2

**FIG. 4**

BL0    BL1

SPEICHER ZELLE

AUSGANGS-VERSTÄRKER

VOM BIT-DECODER

21    A

18    19    20

D    R

VR

VR    VR ≈ -4V

K

VOM DATENEINGANG

CHIP-AUSWAHL

TAKT    RUHEZUSTAND

VR    17

1